(19) Europäisches Patentamt

European Patent Office

Office européen des brevets

(11) **EP 2 278 343 A2**

(12) **EUROPEAN PATENT APPLICATION**

(43) Date of publication:
26.01.2011 Bulletin 2011/04

(51) Int Cl.:
*G01R 13/02* (2006.01)　　　*G01R 23/16* (2006.01)

(21) Application number: 10251272.0

(22) Date of filing: 16.07.2010

(84) Designated Contracting States:
AL AT BE BG CH CY CZ DE DK EE ES FI FR GB
GR HR HU IE IS IT LI LT LU LV MC MK MT NL NO
PL PT RO SE SI SK SM TR
Designated Extension States:
BA ME RS

(30) Priority: 20.10.2009 IN MU17112009
24.07.2009 IN MU17112009 P

(71) Applicant: Tektronix, Inc.
Beaverton, Oregon 97077-0001 (US)

(72) Inventors:
• Ramesh, P.E.
Bangalore 56008 (IN)
• Pickerd, John J.
Hillsboro
Oregon 97123 (US)

(74) Representative: Brinck, David John Borchardt et al
R.G.C. Jenkins & Co
26 Caxton Street
London SW1H 0RJ (GB)

(54) **Method of making frequency domain measurements on a time domain instrument**

(57) A system and method of making frequency domain measurements on a waveform acquired by a time domain instrument, such as an oscilloscope, uses built-in FFT spectral analysis in the time domain instrument so that a user can perform the compliance measurements using the oscilloscope alone. The results of the measurement made by the oscilloscope are made comparable to those made by a spectral analyzer by improving dynamic range, noise floor, and measurement accuracy, by averaging on the time domain oscilloscope.

Figure 9

EP 2 278 343 A2

**Description**

Field of the Invention

The present invention relates generally to signal testing and measurements on oscilloscopes.

Claim for Priority

The subject application claims priority from Indian Provisional Patent Application Serial No. 1711/MUM/2009 A SYTEM AND METHOD OF MAKING THE FREQUENCY DOMAIN MEASURMENTS ON THE TIME DOMAIN ACQUIRED WAVEFORM BY USING THE BUILT IN FFT SPECTRAL ANALYSIS, (P.E. Ramesh, et al.), filed 24 July 2009, and from Indian Patent Application Serial No. 1711/MUM/2009 A SYTEM AND METHOD OF MAKING THE FREQUENCY DOMAIN MEASURMENTS ON THE TIME DOMAIN ACQUIRED WAVEFORM BY USING THE BUILT IN FFT SPECTRAL ANALYSIS, (P.E. Ramesh, et al.), filed 20 October 2009.

Background of the Invention

Increasing data rates require the equipment used in transmission reception, as well as the medium, to conform to various standards in order to maintain the accuracy of the signals. Accordingly, the test and measurement equipment needed to be able to make such measurements must take into account these increased requirements imposed by the current state of the art.

For instance, a 10GBASE-T uses 4 pairs of transmission lines and operates at a data rate of 10GB/s by transmitting 2.5 GB/s over each pair .The intent of the 10GBASE-T is to operate at 10GB/s speed over the existing cable infrastructure. However, due to the greater bandwidth, there is significantly more cross-talk from the adjacent channel. Thus, with this in mind, Digital Signal Processors have been designed in such a way that the suppression on the signal is sufficient to enable the signal to be carried by Cat6a and Cat6e cable. A 10GBASE-T uses 16-Level PAM signaling in each pair, the signal being digitally processed, coded, and then each symbol being converted into one of the PAM 16 values before being transmitted.

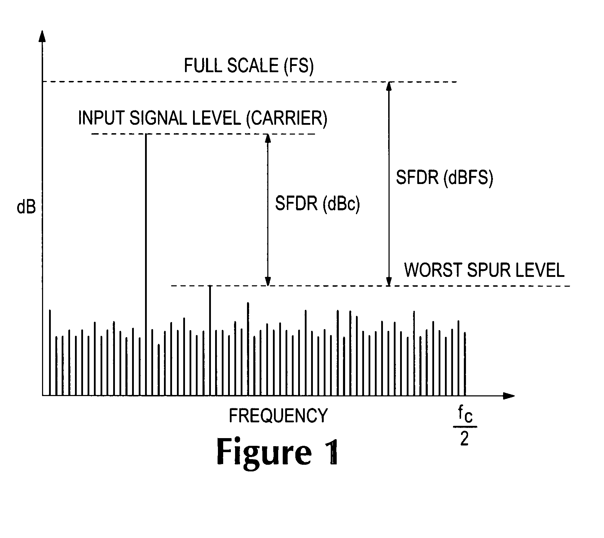

Referring to FIGURE 1, the linearity of the 10GBASE-T is determined by measuring the Spurious Free Dynamic Range (SFDR), which is the ratio of the level of the input signal to the level of the largest distortion component in the spectrum, or largest intermediation product when two tone frequencies are used for the measurement as shown in FIGURE 1.

Linearity determines the minimum signal level that can be distinguished from the distortion components of the signal. This also indicates the digital output fidelity with respect to the original signal. The spurious signal occurs as a result of non-linearity in the signal, and is not necessarily due to the harmonics of the input signal. So, it is measured as the ratio of fundamental signal amplitude to the largest spurious peak that occurs on the spectrum within the signal bandwidth or Nyquist bandwidth.

SFDR is generally measured by setting the oscilloscope to display the fundamental signal near full scale, whereas the other components fall several decibels below the full scale level. Due to non-linearity of the Digital-to-Analog Converter (DAC) (not shown) of the oscilloscope's data acquisition channel, the spurs may not be a direct harmonic of the input signal. So, the SFDR takes into consideration all the sources of distortion regardless of their origin.

In 10 GBASE-T, the linearity is measured on the two tone signal generated by the device under test (DUT). The two tones are f1 and f2 which are relatively close together in frequency; the Inter-modulation Distortion (IMD) products of the 2nd and 3rd order appear in the frequency band of interest. This appears as a small frequency component; if the IMD products are aliased, then it will mask the spur. So, it is important to set the necessary sample rate such that IMD will not mask the spur.

Spurious free dynamic range (SFDR) reflects the usable dynamic value of the DAC before spurious signals distort the fundamental signal. SFDR is the measure of the difference in amplitude between the fundamental and the largest harmonically or non-harmonically related spur, from DC to the full Nyquist bandwidth of the DAC (here in the experimental set up, the Clock rate is 800 MHz, so SFDR is measured in the frequency range from 1 MHz to 400 MHz)

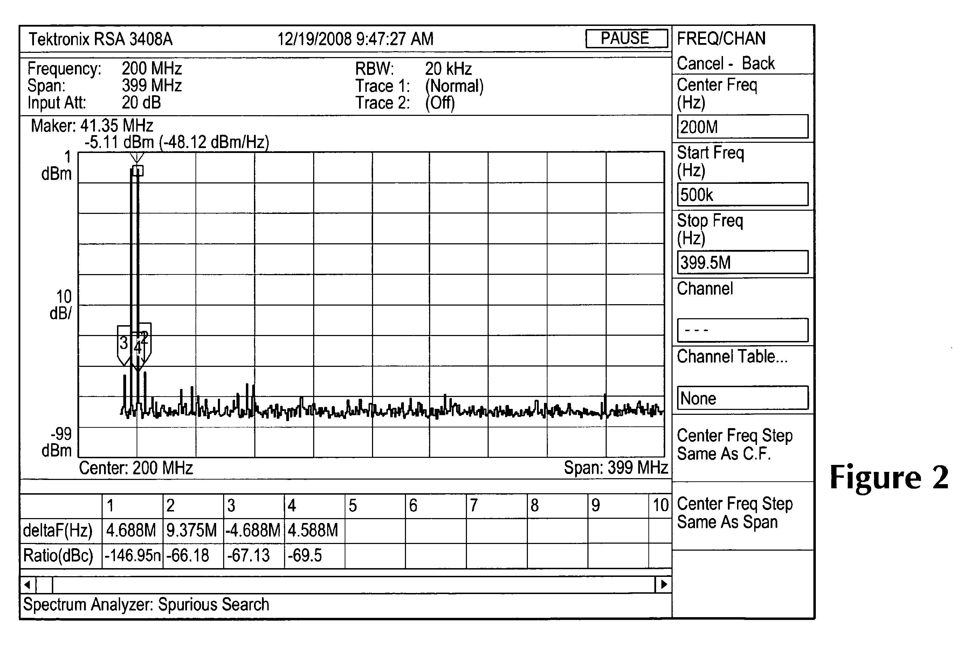

In such scenario, the frequency span is set to 400 MHz to cover the bandwidth of the channel. SFDR is measured by operating the Device Under Test (DUT) to generate the different combinations of two tone signals. Spectrum analyzers are used to perform this measurement where the Span, RBW is set using the peak detection feature. Both the fundamental and spur are identified as a 3rd peak, the first two peaks represent the two tone fundamental frequencies, the third peak is the spur. The difference between the fundamental and the third peak is the SFDR value as shown in FIGURE 2.

As may be seen, the fundamental signal is very close to 0 dB, whereas the third peak (Spur) is below the fundamental signal by about - 67 dB, the SFDR is about the 67 dB for the two tone signals.

Summary of the Invention

An object of the invention is to enable a user to perform a plurality of measurements on a real time oscilloscope.

In accordance with this, the embodiments herein describe a system and a method that enables a user to perform a plurality of measurements on a real time oscilloscope.

In one embodiment herein, the real time oscilloscope may have built-in FFT spectral analyzer. The measurements of frequency domain are made on the time domain acquired waveform so that the user can perform the compliance measurements using the oscilloscope alone. The results of the measurement from the oscilloscope become comparable to spectral analyzer by improving dynamic range, noise floor, and measurement accuracy by averaging on the time domain oscilloscope.

The plurality of measurements includes, but is not limited to, the time domain measurements of droop, jitter, and clock frequency, and the frequency domain measurements of linearity, PSD, and power level.

For improving the noise floor, sample rate of the signal being measured is kept non-multiples of any of the tone frequency thereby spreading the noise equally across the frequency range up to Fs/2, where Fs is the sample rate.

The averaging includes linear averaging on the spectral domain which combines N spectral with equal weighting.

SFDR is measured from the spectral waveform by an algorithm comprising the steps of finding peak value of two tone frequency; finding the third peak on the spectrum; measuring the spectral level between the lower amplitude tone and third peak; and comparing the measured value with limit value arrived based on the identified tone frequency and giving the verdict as pass or fail.

Other objects, features and advantages of the invention will be apparent from the drawings, and from the detailed description that follows below.

Brief Description of the Drawings

Reference will be made to embodiments of the invention, examples of which may be illustrated in the accompanying FIGURES. These FIGURES are intended to be illustrative, not limiting. Although the invention is generally described in the context of these embodiments, it should be understood that it is not intended to limit the scope of the invention to these particular embodiments.

FIGURE 1 shows the concept of spurious frequency dynamic range.

FIGURE 2 shows spurious frequency dynamic range measurements using spectrum analyzer.

FIGURE 3 shows the limits for the two tone frequency measurements used in one embodiment of the present invention.

FIGURE 4 shows the effect of the ratios of sampling clock to the input frequency on SFDR.

FIGURES 5A and 5B show measured SFDR at 3.13 Gs/sec and Measured SFDR at 25 Gs/sec as per one embodiment of the present invention.

FIGURES 6A and 6B show the effect of averaging as per one embodiment of the present invention.

FIGURE 7 shows the need of the windowing technique used in the present invention.

FIGURES 8A and 8B show the effect of windowing as per one embodiment of the present invention.

FIGURE 9 shows the method for making the frequency domain measurements on the time domain acquired waveform by using the built in FFT spectral analysis as per one embodiment of the present invention.

FIGURE 10 shows the linearity measurement plot as per one embodiment of the present invention.

FIGURE 11 shows the peak value energy spreads across many frequency points for understanding of the present invention.

Detailed Description of the Preferred Embodiments

The invention described herein is explained using specific exemplary details for better understanding. However, the invention disclosed can be understood and practiced by a person skilled in the art without the use of these specific details. The invention can be implemented into various types of digital storage oscilloscopes. Further, the invention may be implemented in hardware as well as software.

A system and method of making the frequency domain measurements on the time domain acquired waveform by using the built in FFT spectral analysis is described. This invention enables users to perform all the measurements using a real time digital storage oscilloscope. This involves overcoming the limitations of oscilloscope-based spectral analysis, minimizes the errors, and make the results comparable to that realized by use of a spectrum analyzer, so that the customer can perform the compliance measurements using oscilloscope alone.

The invention involves improving the Dynamic range, Floor Noise, and measurement accuracy by averaging on the time domain oscilloscope.

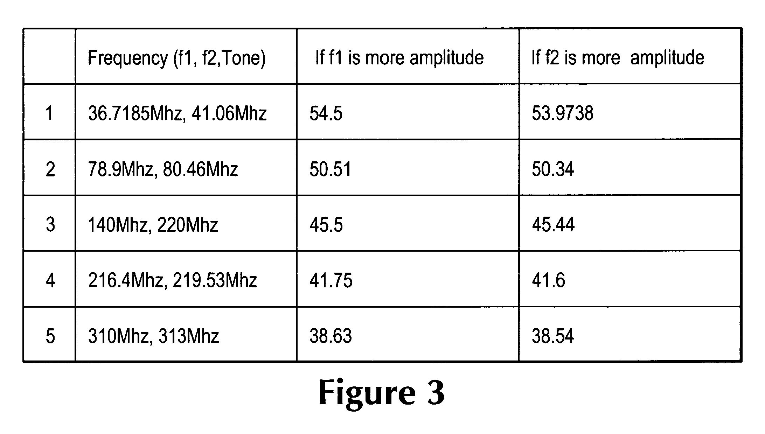

Generally, the amplitude of the two tone signal can differ by about 0.5 dB, the limits are based on the frequency value and its amplitude. FIGURE 3, shows the limit value for the measurement and this needs to be applied based on whichever tone has higher magnitude level.

As per one embodiment of the present invention the limits for the two tone frequency measurements is as shown in FIGURE 3.

It is important to have enough dynamic range and necessary noise floor so that the signal can be measured with good margin. Minimum dynamic range needs are ~55 dB for this measurement. Advantageously, the invention improves the measurement dynamic range by improving the noise floor on the oscilloscope.

Improving the noise floor:

The distribution of the quantization noise plays an important role in determining the minimum levels that can be measured. If the sampling frequency is the integral of the input signal frequency, then noise will be concentrated on the harmonics of the fundamental frequency. If the ratio is an odd number, then the quantization noise is be distributed across all frequencies and improves the dynamic range.

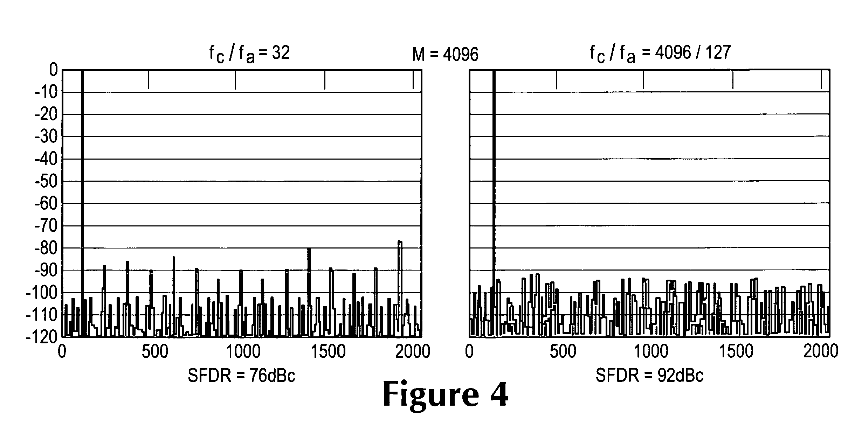

FIGURE 4 shows the effect of the ratios of sampling clock to the input frequency on SFDR. It is clear from FIGURE 4, that the non-coherence between the sample rate and fundamental frequency improves the SFDR by about 16 dBc.

So for this measurement, it was ensured that the sample rate is not a multiple of any tone frequency. The artifacts due to quantization noise are minimized by choosing the sample rate to signal frequency ratios. The noise is not of integral multiples in nature, so the noise will be equally spread across the frequency range up to Fs/2.

Further, an oscilloscope having an 8 bit Analog-to-Digital (A/D) converter was used and the signal was set to about 8 full divisions, rather than 10 divisions to avoid clipping. So, the number of Digital levels for 8 divisions may be given as:

$$Dls = 8 * 25 = 200 \text{ levels.}$$

200 levels correspond to 7.645 bits rather than 8 bit.

Therefore,,

$$SNR = 6.02*7 + 1.76 = 43.76 \text{ dB}$$

Even though the SNR is 48 dB, the FFT noise floor is not the SNR, because the FFT acts like an analog spectrum analyzer with a bandwidth of. Fs *K/RL where RL is the number of data points considered for the FFT and K is a constant depending on which window function is used.

The Theoretical Noise floor will be well below the quantization noise floor due to process gain of the FFT.

The process gain increases the SNR if the signal is over sampled more number of times than the occupied signal bandwidth.

$$SNR = SNR = 6.02N + 1.76dB + 10\log_{10}\frac{fs}{2 * BW} \qquad Eq\ (1)$$

The process gain significantly improves the measurement capability of SFDR. In this application, the sample frequency chosen is 25 GS/Sec(fs) , Bandwidth is 20KHz (BW).

This result in process gain is as shown below:

Process Gain = 10*log (25e9/20e3) = 57dB.

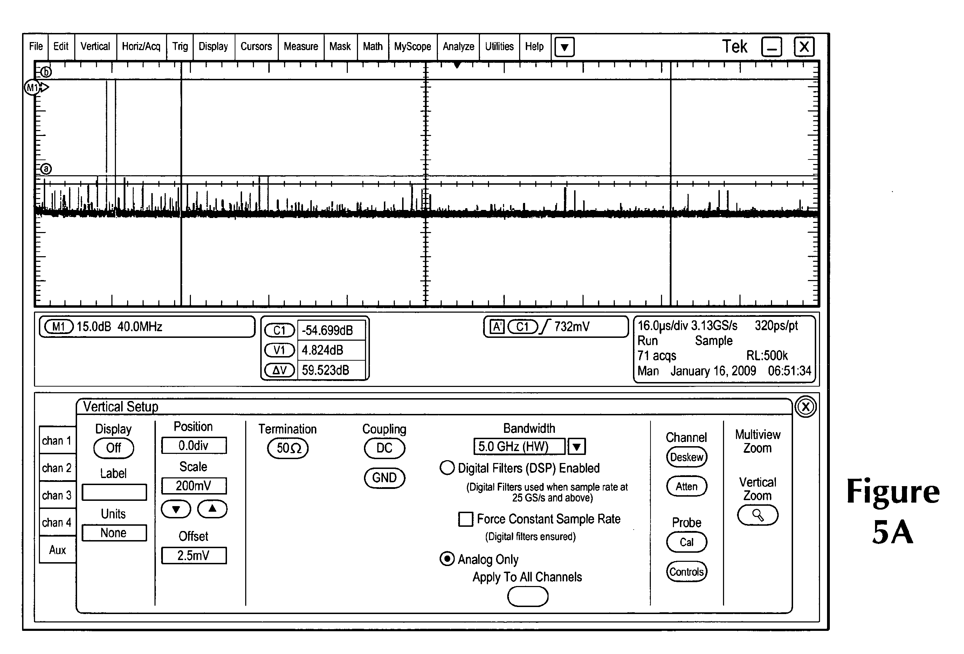

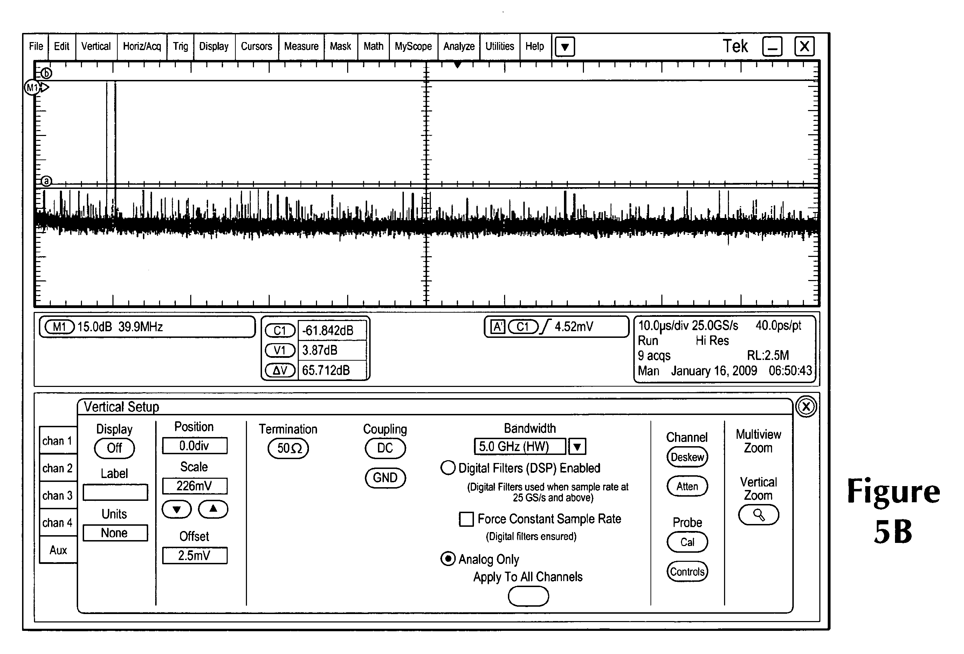

In this embodiment, a 2.5M record length was carefully chosen for this measurement to achieve the desired noise floor. The total floor noise is 57 + 43 = 100 dB; however the noise floor of the oscilloscope is limited from 90 to 95 dB as shown in FIGURE 5. FIGURE 5 also shows the signal fidelity to perform the linearity measurement. The measurement of dynamic range for the given signal at 3.13 GS/s and at 25 GS/s can be seen in FIGURE 5, as per one embodiment of the present invention.

As may be seen, the floor noise is more at 3.13 GS/s compared to at 25 GS/s where this is improved by more than 10 dB. Similarly, the ability to detect the Spur level is improved for the given signal from 59 dB to 65 dB (about 6 dB more), there was 7 dB improvement by increasing the sample rate.

Spectral Averaging:

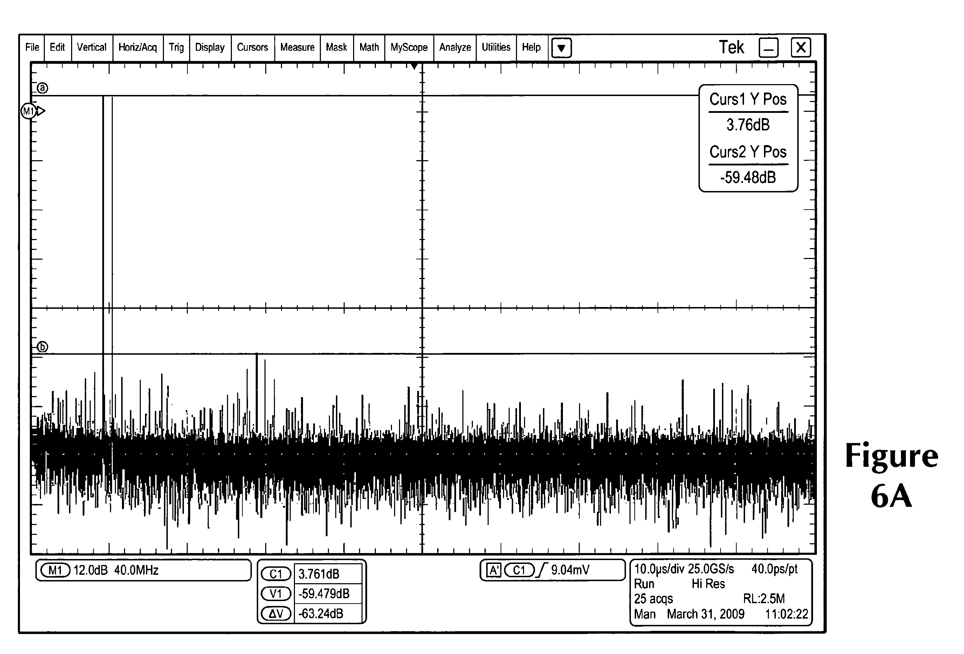

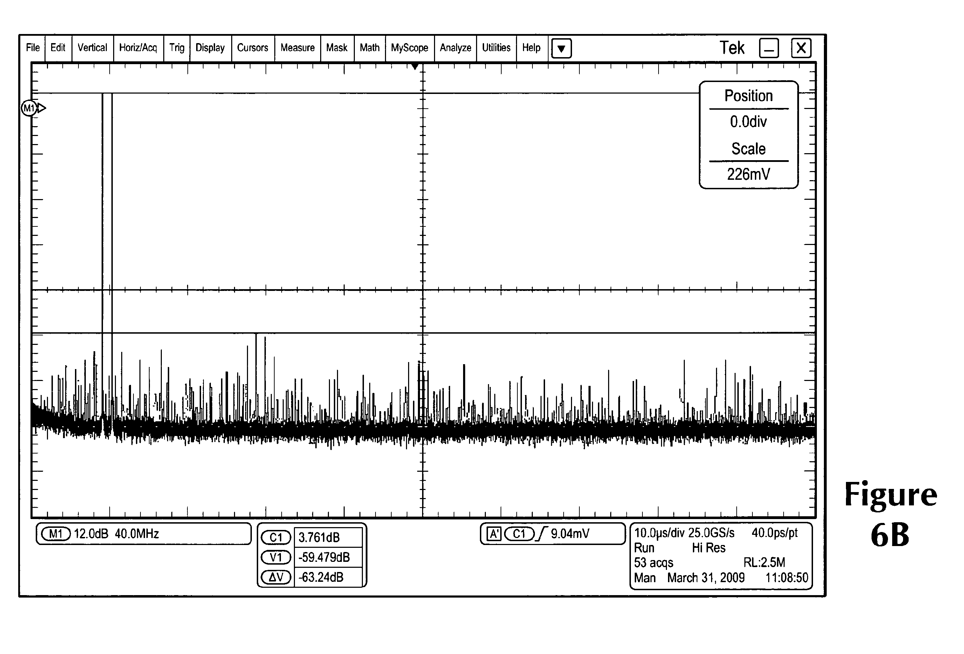

FIGURE 6 shows the effect of averaging, as per one embodiment of the present invention.

There are many types of averaging. For example, there are RMS, Vector, Peak hold, and Linear averaging. In this case, linear averaging was used for spectral averaging since the linear averaging combines N spectra with equal weighting. The measured signal is not repetitive in nature, so the signal was averaged in the spectral domain rather than in the time domain. When the linear averaging is in progress, the waveform is continually displayed. This averaging helps to reduce the noise and spectral content of low magnitude from the high noise floor. The spectral averaging reduces the variation of the noise floor and if the signal has spectral component that will stand out of the noise floor clearly.

Windowing:

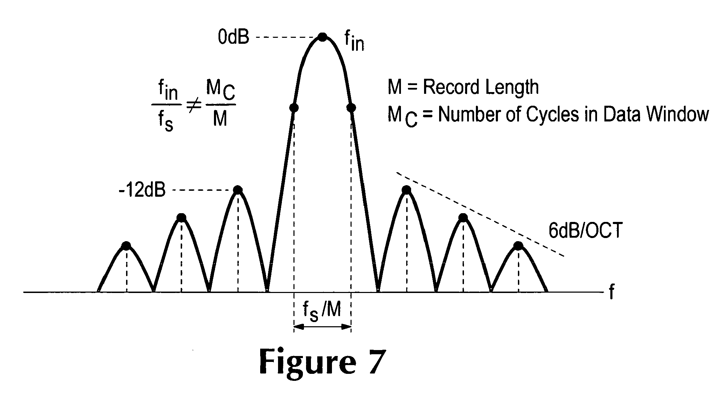

FIGURE 7 shows the need of the windowing technique used in the present invention. When the sample frequency is not a multiple of the measured frequency, then spectral leakage occurs. As per one embodiment herein, in this measurement the sample rate is intentionally not set as the integral of the signal frequency because a requirement of the invention is to distribute the quantization noise throughout the frequency range Fs/2 randomly, so that it will not impact the linearity measurement. A discontinuity occurring at the end of the data window will result in leakage at frequency domain due to the side lobes that are generated .The side lobes are as shown in FIGURE 7.

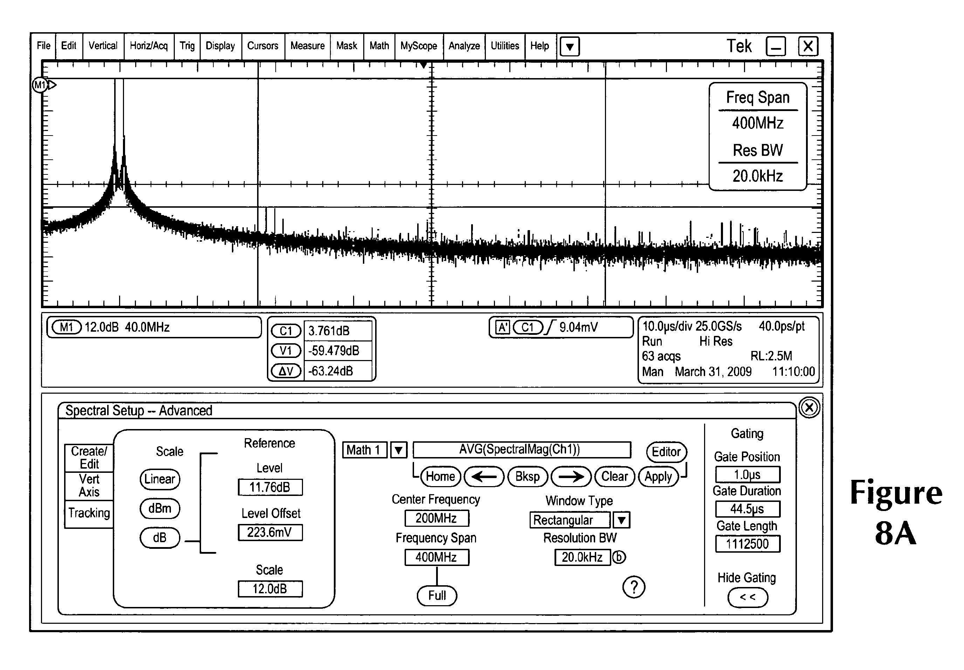

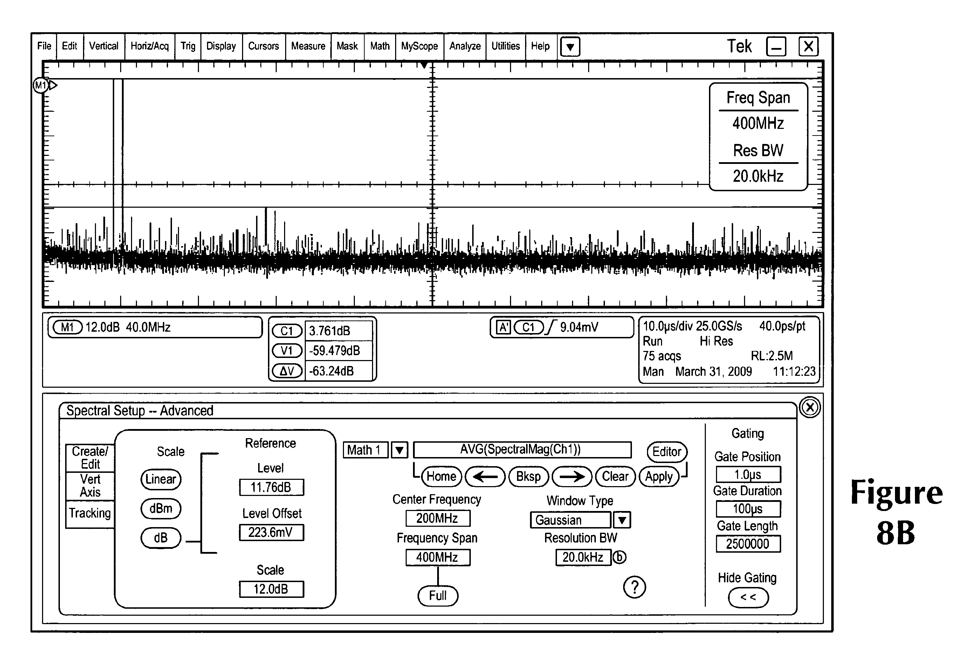

These side lobes are minimized by choosing an appropriate window function other than the rectangular window. Here, the input samples are multiplied by a window function that brings the edges of the data to zero value. As per the embodiments of the present invention, a Gaussian window is used that separates out the frequency component clearly, as compared to the rectangular window. This is shown in FIGURE 8.

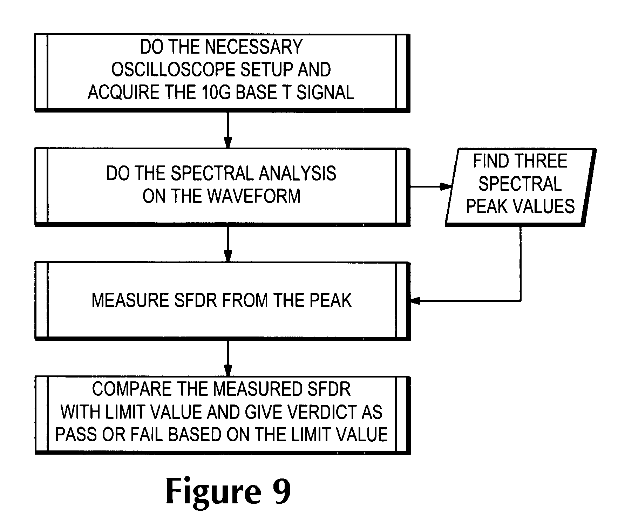

FIGURE 9 shows a flowchart of the method of making the frequency domain measurements on a waveform that was acquired in the time domain, by using the built in FFT spectral analysis.

As per one embodiment, the method is explained as broadly including the following steps:

Find the Peak value of the Two tone frequency

Find the third peak on the spectrum

Measure the spectral level between the lower amplitude tone and third peak

Compare the measured value with limit value arrived based on the identified tone frequency and give the verdict as pass or fail.

The method of finding the Spectral peaks is as detailed below:

The spectral waveform has the data point separated by frequency interval based on the sample rate and record length being considered for spectral analysis, Let L be the number of data points in the time domain,

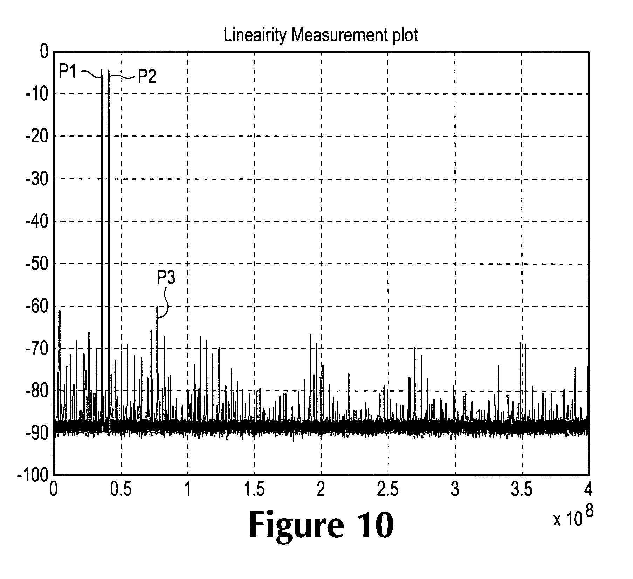

To measure the SFDR, the three peaks namely P1, P2, and P3 are identified as shown in FIGURE 10. Generally, P3 will be the multiples of fundamental Harmonics frequency.

Further, the most common value on the spectral analysis is identified using the histogram method. Let the signal in the time domain be v(n ) where n varies from 1 to L, where L is the number of waveform data points.

FFT (v (n)) = V (x), where x varies from 1 to L/2.

The V (x) of each record point represent the spectral value at the k times the frequency samples.

$$\text{Frequency Sample interval Rbw} = Fs*K/L \qquad EQ(2)$$

Even though, when the time domain signal is converted to frequency domain, the signal level is spread across multiple frequency points. Not all the data points in the frequency spectrum will have enough amplitude; most of the amplitude will be low except at the tone frequency and multiple of tones frequency and spurious frequency. Otherwise amplitude takes the most common value shown here as floor noise.

The P1 is identified as the max of the spectral data by sorting.

V(x) represents the spectral waveform.

The array, SV(m), is a sorted value of V(x). We keep the track of index of x for each value of 'm' here.

$$P1 = SV(0) \qquad EQ(3)$$

$$P2 = SV(1) \qquad EQ(4)$$

Now, it is also identified that SV ( 0 ), SV(1) is the k and $m^{th}$ index on the V(x) waveform. In this method, traversing on the V(x) data from k and $m^{th}$ index is made back and fourth until the most common value is reached.
Z is the most common value on the spectrum and is nothing but a floor noise and is obtained using the histogram method applied above for the spectral levels;
$$Z = \text{Histogram of } (V(x)) \qquad EQ(5)$$

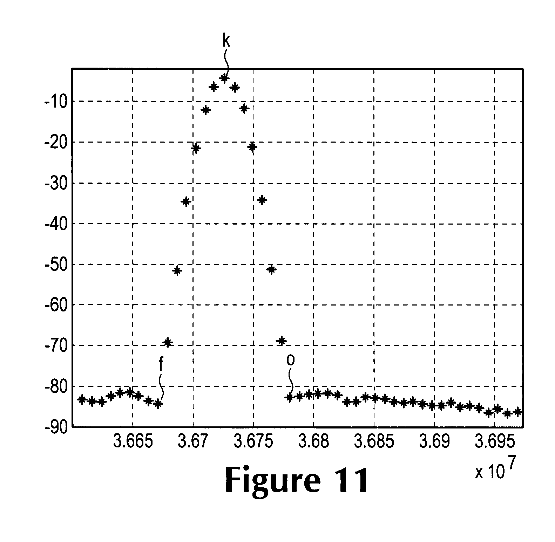

Not all the frequency points around the peak value are of another peak frequency, since the peak value energy spreads across many frequency points as shown the in FIGURE 11. Here, the Peak value index is k, but this frequency component gets back to the noise floor at index point for o on the spectrum. Therefore, point f to point o on the spectrum corresponds to one frequency.
$$\text{Let } V(k\text{-}f) = Z$$

$$\text{Let } V(k\text{+}o) = Z,$$

Now make
V(x) = Z for all values of x from k-f to k+ o value
Similarly for P2, also make
V(x) = Z for m-f to m+o value
Once again sort the V(x); The sorted value is SV(m)
$$P3 = SV(0) ;$$

$$SFDR = \text{Min}(P1,P2 ) - P3 ;$$

Let the frequency sample interval be j, then the Tone frequencies are
$$T1 = j*k$$

$$T2 = j*m$$

Compare the measured SFDR with the applicable limit value and if the value is less than the limit value, then it fails, otherwise it is passes.

The foregoing description of the invention has been described for purposes of clarity and understanding. It is not intended to limit the invention to the precise form disclosed. The subject invention is intended to be limited only by the following claims.

**Claims**

1.  A method for enabling a user to perform a plurality of measurements on a real time oscilloscope, the method comprising the steps of:

    providing a real time oscilloscope having built-in FFT spectral analyzer capability;
    coupling the real time oscilloscope to a device under test for receiving a signal under test in the time domain therefrom;
    performing measurements in the time domain and in the frequency domain on the signal acquired in the time domain.

2.  The method of claim 1, wherein the plurality of measurements includes, but is not limited to, the time domain measurements of droop, jitter, and clock frequency, and the frequency domain measurements of linearity, PSD, and power level.

3.  The method of claim 1, wherein results of the measurement made by the oscilloscope becomes comparable to those made by a spectral analyzer by improving dynamic range, noise floor, and measurement accuracy by averaging on the time domain oscilloscope.

4.  The method of claim 3, wherein for improving the noise floor, the sample rate of the signal being measured is set to be a non-multiple of either of a pair of tone frequencies thereby spreading the noise equally across the frequency range up to Fs/2.

5.  The method of claim 3, wherein the averaging includes linear averaging on the spectral domain which combines N spectra with equal weighting.

6.  The method of claim 1, wherein measurement of SFDR is performed from the spectral waveform by a process comprising the steps of:

    finding peak value of two tone frequency;
    finding a third peak on the spectrum; measuring the spectral level between the lower amplitude tone and the third peak; and
    comparing the measured value with a limit value arrived at based upon the identified tone frequency; and giving a verdict as pass or fail.

FULL SCALE (FS)

INPUT SIGNAL LEVEL (CARRIER)

SFDR (dBFS)

dB

SFDR (dBc)

WORST SPUR LEVEL

FREQUENCY $\dfrac{f_c}{2}$

# Figure 1

| | Tektronix RSA 3408A | 12/19/2008 9:47:27 AM | PAUSE |
|---|---|---|---|

Frequency: 200 MHz  RBW: 20 kHz
Span: 399 MHz  Trace 1: (Normal)
Input Att: 20 dB  Trace 2: (Off)

Maker: 41.35 MHz
-5.11 dBm (-48.12 dBm/Hz)

Center: 200 MHz  Span: 399 MHz

| | 1 | 2 | 3 | 4 | 5 | 6 | 7 | 8 | 9 | 10 |
|---|---|---|---|---|---|---|---|---|---|---|
| deltaF(Hz) | 4.688M | 9.375M | -4.688M | 4.588M | | | | | | |
| Ratio(dBc) | -146.95n | -66.18 | -67.13 | -69.5 | | | | | | |

Spectrum Analyzer: Spurious Search

FREQ/CHAN

Cancel - Back

Center Freq (Hz)

200M

Start Freq (Hz)

500k

Stop Freq (Hz)

399.5M

Channel

- - -

Channel Table...

None

Center Freq Step Same As C.F.

Center Freq Step Same As Span

**Figure 2**

EP 2 278 343 A2

| | Frequency (f1, f2,Tone) | If f1 is more amplitude | If f2 is more amplitude |
|---|---|---|---|
| 1 | 36.7185Mhz, 41.06Mhz | 54.5 | 53.9738 |
| 2 | 78.9Mhz, 80.46Mhz | 50.51 | 50.34 |
| 3 | 140Mhz, 220Mhz | 45.5 | 45.44 |
| 4 | 216.4Mhz, 219.53Mhz | 41.75 | 41.6 |
| 5 | 310Mhz, 313Mhz | 38.63 | 38.54 |

# Figure 3

EP 2 278 343 A2

Figure 4

EP 2 278 343 A2

Figure 5A

EP 2 278 343 A2

| File | Edit | Vertical | Horiz/Acq | Trig | Display | Cursors | Measure | Mask | Math | MyScope | Analyze | Utilities | Help | ▼ | Tek | ▢ | ☒ |

(M1) 15.0dB  39.9MHz

(C1) -61.842dB
(V1) 3.87dB
(ΔV) 65.712dB

(A)(C1) / 4.52mV

10.0µs/div 25.0GS/s    40.0ps/pt
Run        Hi Res
9 acqs                  RL:2.5M
Man   January 16, 2009   06:50:43

**Vertical Setup** ⊗

| chan 1 | Display (Off) | Position 0.0div | Termination (50Ω) | Coupling (DC) | Bandwidth 5.0 GHz (HW) ▼ | Channel (Deskew) | Multiview Zoom |
| chan 2 | Label | Scale 226mV | | (GND) | ◯ Digital Filters (DSP) Enabled | (Atten) | Vertical Zoom |
| chan 3 | | ▼ ▲ | | | (Digital Filters used when sample rate at 25 GS/s and above) | | (🔍) |
| chan 4 | Units None | Offset 2.5mV | | | ☐ Force Constant Sample Rate (Digital filters ensured) | Probe (Cal) | |
| Aux | | | | | ⦿ Analog Only  Apply To All Channels | (Controls) | |

**Figure 5B**

Figure
6A

Figure
6B

0dB ----- $f_{in}$

$$\frac{f_{in}}{f_S} \neq \frac{M_C}{M}$$

M = Record Length
$M_C$ = Number of Cycles in Data Window

-12dB ------

6dB/OCT

$f_S/M$

f

**Figure 7**

Figure 8A

EP 2 278 343 A2

| File | Edit | Vertical | Horiz/Acq | Trig | Display | Cursors | Measure | Mask | Math | MyScope | Analyze | Utilities | Help | ▼ | Tek | ☐ | ☒ |

M1

**Freq Span**

400MHz

**Res BW**

20.0kHz

M1 12.0dB  40.0MHz

C1  3.761dB
V1  -59.479dB
ΔV  -63.24dB

A' C1 ╱ 9.04mV

10.0µs/div 25.0GS/s   40.0ps/pt
Run      Hi Res
75 acqs          RL:2.5M
Man   March 31, 2009    11:12:23

**Spectral Setup -- Advanced**  ⊗

Create/Edit
Vert Axis
Tracking

Scale

Linear
dBm
dB

Reference
Level
11.76dB
Level Offset
223.6mV
Scale
12.0dB

Math 1 ▼   AVG(SpectralMag(Ch1))   Editor

Home  ←  Bksp  →  Clear  Apply

Center Frequency
200MHz

Frequency Span
400MHz
Full

Window Type
Gaussian ▼

Resolution BW
20.0kHz ⓑ

?

Gating

Gate Position
1.0µs
Gate Duration
100µs
Gate Length
2500000

Hide Gating
<<

**Figure 8B**

DO THE NECESSARY
OSCILLOSCOPE SETUP AND
ACQUIRE THE 10G BASE T SIGNAL

DO THE SPECTRAL ANALYSIS
ON THE WAVEFORM

FIND THREE
SPECTRAL
PEAK VALUES

MEASURE SFDR FROM THE PEAK

COMPARE THE MEASURED SFDR
WITH LIMIT VALUE AND GIVE VERDICT AS
PASS OR FAIL BASED ON THE LIMIT VALUE

Figure 9

Figure 10

**Figure 11**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

*   WO 1711MUM2009 A